# EUROPEAN PATENT APPLICATION

(11) **EP 4 765 789 A2**
(43) Date of publication of application: **24.06.2026**
(21) Application number: 26168597.8
(22) Date of filing: 17.07.2020
(51) Int. Cl.: H04M 1/72406

(54) **IN-APPLICATION STORE USER INTERFACE**

(62) Divisional of application: 20945153.3
(71) Applicant: Google LLC, Mountain View, CA 94043 (US)
(72) Inventor: JIN, Tianpeng, Mountain View, 94043 (US); ZHAO, Xuanang, Mountain View, 94043 (US); XING, Miao, Mountain View, 94043 (US); SHIMKO, Thomas, Andrew, Mountain View, 94043 (US); NEJAD, Siavash, Sedigh, San Francisco, 94102 (US); EBBITT, Kenneth, Cooper, Mountain View, 94043 (US); WANG, Chaohui, Mountain View, 94043 (US); ZHU, Chunlei, Mountain View, 94043 (US)
(74) Representative: Marks & Clerk GST

(57) **Abstract**

A computer-implemented method comprising: receiving, by an application (108) executing on a user device (102) that is not an application store, a single content response from a content server (120), wherein the single content response comprises both digital content (112) referencing a second application that is not installed on the user device and application store data (116) for the second application; in response to receiving the single content response and when the application is an active application, providing, by the active application and in a user interface (110) of the active application, the digital content concurrently with an application store user interface (114) that includes (i) the application store data for the second application and (ii) an install element (118) for triggering installation of the second application on the user device from within the active application; detecting user interaction with the install element provided within the user interface of the active application; and in response to detecting the user interaction with the install element, triggering a download of the second application independent of launching an application for the application store.

## Description

### BACKGROUND

Applications, e.g., web browsers or other native applications, can present content that includes a link to another application. For instance, a news application can present content that includes a link to send information about a news article using an email application. In response to receipt of data that indicates selection of the link, the news application can launch the email application to enable sending information about the news article via email.

### SUMMARY

Aspects of the present invention provide a computer-implemented method, non-transitory computer readable medium, and a system as set out by the appended set of claims. A user device can automatically present, in an active application executing on the client device, an application store user interface overlaid on top of a portion of the active application's user interface. The application store user interface includes content for a second application to enable installation of the second application on the client device without having to navigate away from, or closing, the active application. The user device can automatically present the application store user interface after presentation of a video in the active application, after presentation of content, e.g., an image, for a predetermined period of time, or after another appropriate trigger. This can enable the user device to install the second application without having to launch the application store (e.g., in another application), requiring user input that indicates that the user device should present the application store user interface, or both.

In some implementations, the active application can present the application store user interface as an embedded portion of the active application's user interface, such that the application store user interface is presented directly within the active application. For instance, the active application can present content concurrently with the presentation of the application store user interface. The active application can present, in a user interface for the active application, a video or an image in one portion of the user interface and an embedded application store user interface in another portion of the user interface. In some examples, an embedded application store user interface can be embedded within content, such as an image, displayed in an active application's user interface. In this specification, an embedded application store user interface can be embedded either in content displayed in the active application's user interface, e.g., an image, or directly in the active application's user interface itself.

In these implementations, the embedded application store user interface can include a size control that enables user input to change a size of the other portion in which the embedded application store user interface is presented. For example, the active application can determine a size of the portion for the video or the image based on the content of the video or the image. When the video or the image is square, e.g., in a preferred aspect ratio, the active application can determine a size for the other portion to maintain the square size of the video or the image. The active application then presents the embedded application store user interface in a remaining portion of the active application's user interface.

Upon receipt of data that indicates selection of the size control for the embedded application store user interface, the active application can dynamically change the size of the other portion in which the embedded application store user interface is presented. This can cause more or less information for the embedded application store user interface to be presented in the active application's user interface.

The subject matter described in this specification can be implemented in various embodiments and may result in one or more of the following advantages. Because the application store user interface is presented as part of the application's user interface, the active application can enable installation of another application without requiring the user device to switch from the active application to a separate instance of an application store, thereby preventing an application store application from being launched by the client device. This reduces the amount of processor and memory resources that must be used by the client device to present the application store interface because the client device simply presents the application store interface within an already launched application rather than having to utilize additional memory and processor cycles to launch another application. In other words, the application store interface can be rendered, displayed and interacted with within the already launched application, for which computational resources have already been reserved, without requiring additional computational resources to be reserved for a separate instance of an application store. Moreover, by enabling rendering of, display of and interaction with the application store interface within the already launched application, computational overheads associated with running two separate applications can be avoided. Reducing the processor and memory use also reduces the battery consumption, which is limited in the context of mobile devices, thereby extending battery life and allowing for more operations to be performed on a single charge.

Furthermore, the techniques discussed herein can reduce animations presented on a display for the user device, e.g., that indicate switching from a first user interface for the application to a second user interface for the application store, which can also reduce processor consumption and power required to modify pixel color, brightness, or both, required during the animations. The techniques described in this document can reduce an amount of user input received by the user device, e.g., when the user device would otherwise require receipt of data indicating selection of a link or other menu option to cause presentation of the application store user interface, either as an overlaid user interface on top of the application's user interface or as a separate user interface to which the user device switches from the application's user interface. These techniques can reduce the number of clicks or other user interactions with a user interface, e.g., by presenting an application store user interface within another application, either overlaid or embedded. These techniques can also improve accessibility to downloading information from an application store by reducing the amount of time required by a user device to navigate to the application store. The techniques described in this document can enable presentation of detail information for an application that was retrieved from a real application store database without requiring presentation of an application store application.

These techniques can enable more efficient receipt and processing of user input and provide a graphical shortcut enabling more efficient installation of another application by a processor of a user device. Reducing a number of interactions required to install another application can provide more efficient utilization of computational resources through one or more of reducing an amount of time that a user device needs to be active, reducing a number of selectable inputs that need to be rendered, reducing a number of received inputs that need to be processed, or reducing an amount of data that needs to be retrieved from memory or a remote server. These benefits can contribute to more efficient use of available processors, memory, battery and bandwidth. Moreover, when the application store user interface is rendered and displayed after digital content has been displayed in the application user interface for a predetermined period of time, or after another appropriate trigger, the described techniques can extend the functionality and versatility of the already launched application by making the rendering of the application store user interface responsive to the identification or otherwise of received inputs, for example within a predetermined time period. Therefore, in this example, the rendering and display of the application store user interface is only implemented based on the identification or otherwise of user inputs and is avoided otherwise, providing further savings and more efficient use of available computational resources.

In general, one aspect of the subject matter described in this specification can be embodied in methods that include the actions of receiving, by an active application executing on a user device that is not an application store and for display in a user interface of the active application, digital content referencing a second application that is not installed on the user device; obtaining, from one or more servers and by the active application that is not the application store, application store data for the second application that is not installed on the user device; providing, by the active application and in the user interface of the active application, the digital content with an application store user interface that includes (i) the application store data for the second application that is not installed on the user device and (ii) an install element for triggering installation of the second application on the user device from within the active application; detecting user interaction with the install element provided within the user interface of the active application; and in response to detecting the user interaction with the install element, triggering a download of the second application independent of launching an application for the application store. Other embodiments of this aspect include corresponding computer systems, apparatus, computer program products, and computer programs recorded on one or more computer storage devices, each configured to perform the actions of the methods. A system of one or more computers can be configured to perform particular operations or actions by virtue of having software, firmware, hardware, or a combination of them installed on the system that in operation causes or cause the system to perform the actions. One or more computer programs can be configured to perform particular operations or actions by virtue of including instructions that, when executed by data processing apparatus, cause the apparatus to perform the actions.

The foregoing and other embodiments can each optionally include one or more of the following features, alone or in combination. Obtaining the application store data can include receiving, by the active application that is not the application store and from another system, the application store data for the second application that is not installed on the user device. Providing the digital content with the application store user interface can include providing the application store user interface in response to receiving, from the other system, the application store data. Providing the digital content with the application store user interface can include displaying the digital content with the application store user interface. Providing the digital content with the application store user interface can include providing, to a display unit, data for the digital content and the application store user interface to cause the display unit to display the digital content and the application store user interface.

In some implementations, providing the digital content with the application store user interface that includes the application store data can include presenting, in the user interface of the active application, the digital content with an embedded application store user interface that includes the application store data. Providing the digital content with the application store user interface that includes the application store data can include presenting the digital content with an overlaid application store user interface that includes the application store data. The method can include displaying, by the active application, the digital content in the user interface without the application store data; and determining that a presentation time period of the digital content is satisfied. Displaying the digital content with the overlaid application store user interface can be responsive to determining that the presentation time period of the digital content is satisfied.

In some implementations, the digital content can include a second application details element. The method can include determining, by the active application, that the active application has not detected user interaction with the second application details element. Displaying the digital content with the overlaid application store user interface can be responsive to: determining that the active application has not detected user interaction with the second application details element; and determining that the presentation time period of the digital content is satisfied.

In some implementations, obtaining the application store data can include obtaining the application store data in a message that includes the digital content. The method can include prior to providing the digital content with the application store user interface, caching the digital content and the application store data; and determining that a presentation criteria is satisfied. Providing the digital content with the application store user interface can be responsive to determining that the presentation criteria is satisfied. Determining that the presentation criteria is satisfied can include detecting, by the active application, a user interaction that requests presentation of the digital content. Providing the digital content with the application store user interface can be responsive to detecting the user interaction that requests presentation of the digital content.

In some implementations, detecting the user interaction that requests presentation of the digital content can include detecting the user interaction that requests presentation of any digital content and does not request presentation of any application store data. Providing the digital content with the application store user interface that includes the application store data can be responsive to detecting the user interaction that requests presentation of any digital content and does not request presentation of any application store data. Obtaining the application store data can include obtaining, from another system, the application store data that was selected based on a determination that the second application is not installed on the user device.

The details of one or more implementations of the subject matter described in this specification are set forth in the accompanying drawings and the description below. Other features, aspects, and advantages of the subject matter will become apparent from the description, the drawings, and the claims.

### BRIEF DESCRIPTION OF THE DRAWINGS

FIG. 1 depicts an example environment in which a user device presents an active application user interface that includes an application store user interface.
FIGS. 2A-B depict an example of a user interface with an embedded application store user interface.
FIG. 3 depicts an example of a user interface with an overlaid application store user interface.
FIG. 4 is a flow diagram of a process for causing presentation of digital content with application store data.
FIG. 5 is a block diagram of a computing system that can be used in connection with computer-implemented methods described in this document.

Like reference numbers and designations in the various drawings indicate like elements.

### DETAILED DESCRIPTION

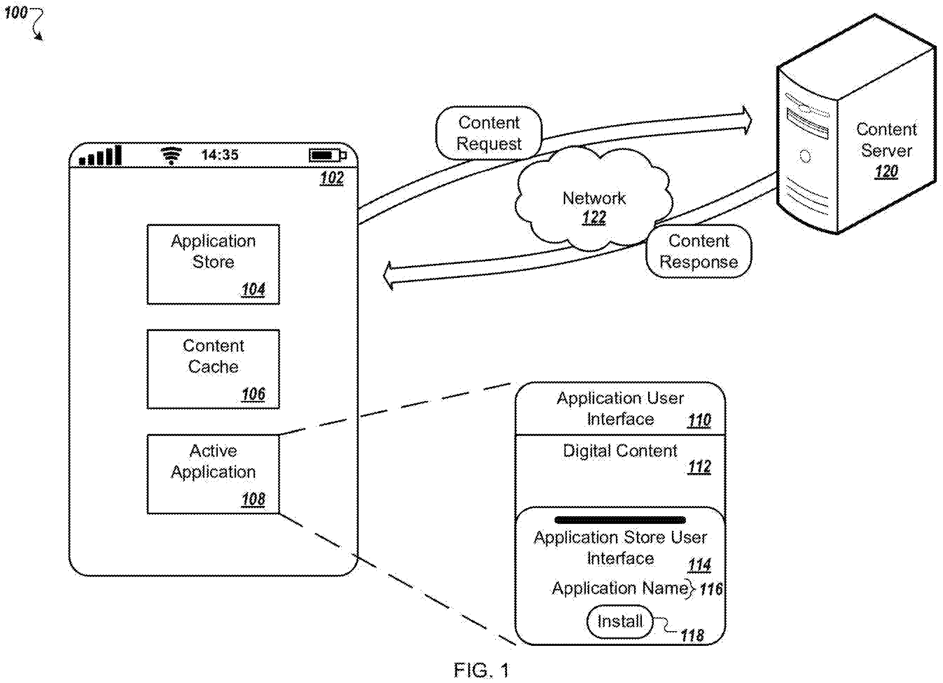

FIG. 1 depicts an example environment 100 in which a user device 102 presents an active application user interface that includes an application store user interface. For instance, an active application 108 executing on the user device 102 can present, as part of its own user interface 110, an application store user interface 114, even though the active application 108 is not part of the application store and the active application itself does not include code for generating the application store user interface 114. As described in more detail below, the active application 108 can present the application store user interface 114 to enable more efficient installation of another application, e.g., that is not installed on the user device 102.

As described in this document, an active application is an application whose interface is presented on a display for the user device 102, e.g., and is not minimized. For example, the active application 108 can include an application user interface 110 that is presented on an integrated display, an external display, or both, that is connected to the user device 102. The active application 108 can provide, to the display or to a graphics processing unit, instructions for presentation of the application user interface 110 that cause the receiving device to present the application user interface 110, including the application store user interface 114, on a display.

The user device 102 includes, or is capable of accessing, an application store 104. The application store 104 is an application that enables the user device 102 to install applications on the user device 102. For instance, the application store 104 can receive, e.g., from an application store server, application store data for an application. The application can be any appropriate type of application available for installation on the user device 102.

The application store 104 can present the application store data in an application store user interface. The application store user interface can include one or more elements that enable user input to search for an application, get more information about an application, install an application, or a combination of these. In some examples, the application store 104 retrieves the application store data for the application in response to receipt of user input that indicates a search for the application.

Separate from the application store 104, the user device 102 includes one or more applications installed on the user device 102, such as the active application 108. The one or more applications can be any appropriate type of application, such as a banking application, a productivity application, a music player, a social media application, or a game. These one or more applications generally will not include code that enables the respective application to generate the application store user interface without receiving data from an external source, as described in more detail below.

Although the active application 108 does not include code that generates the application store user interface, the active application 108 is configured to present digital content, directly within its application user interface 110, that provides an application store user interface 114. The application store user interface 114 includes an install element 118 that enables installation of another application. For example, user interaction with the install element 118 can trigger, or otherwise initiate, a download of the other application from within the active application, e.g., without requiring the user device 102 to leave or otherwise minimize the active application 108. Presentation of the application store user interface 114 in the application user interface 110 can reduce computer resources used to install another application on the user device 102, e.g., by not requiring the user device 102 to launch and present the application store 104.

The application user interface 110 presents content for the active application 108. The content can include content stored locally on the user device 102, e.g., content installed with the active application 108. The content can include content retrieved from a content server 120, e.g., a third party system. For example, when the active application 108 presents dynamic content in the application user interface 110, the active application 108 can request content from the content server 120. Dynamic content can include images, videos, content about embedded files, or other appropriate types of dynamic content, which can include advertising content.

In response to receiving the request, the content server 120 selects content for presentation in the application user interface 110. The content server 120 can select content based on the active application 108, an application type for the active application 108, a profile for the user device 102, data that indicates applications installed on the user device 102, or other appropriate data.

For instance, a document editor, as the active application 108, can present, in the application user interface 110, a document. The document can include unsupported content, such as a worksheet or a music file embedded in the document, and that the document editor is unable to present. When the user device 102 does not include an application that provides functionality for the unsupported content, the document editor can request application content to enable installation of another application that provides functionality for the unsupported content.

When the content server 120 receives the application content request from the document editor, the content server 120 can use data about the user device 102, the document editor, the unsupported content, or a combination of two or more of these, to select application content for a worksheet application, or a music application, depending on the type of unsupported content. The selected application content is for an application that is not installed on the user device 102, e.g., as of a time when the user device 102 sent the content request to the content server 120. The content server 120 provides the selected application content to the active application 108.

The selected application content can include digital content 112, application store data 116, or both. For example, the digital content 112 can reference another application, e.g., that provides functionality for the unsupported content. The digital content 112 can include a name, image, logo, or other data for the other application. The application store data 116 includes data from an application store server that is about the other application. The application store data 116 can include a description of the other application, review data for the other application, a screenshot of an interface for the other application, a video of the other application's use, or other appropriate application store data.

The digital content 112 is different data from the application store data 116. For example, the digital content 112 can be presented directly by the application's own user interface 110, e.g., without an embedded or overlaid user interface for another application, while the application store data 116 is configured for presentation by an application store or in an application store user interface 114 that is presented as part of the application's own user interface 110.

The active application 108 receives a content response, from the content server 120, that includes the digital content 112 and the application store data 116. In some examples, the active application 108 can receive a first response that includes the digital content 112 from a first server, e.g., the content server 120, and a second response that includes the application store data 116 from a second server, e.g., an application store server.

After receiving the content response, the active application 108 presents, in the application user interface 110, the digital content 112 and an application store user interface 114. The application store user interface 114 includes the application store data 116 and the install element 118.

The active application 108 can present the digital content 112 in a content slot in its application user interface 110. The active application 108 can present the application store user interface 114 in the same slot. To present the application store user interface 114 in the slot, or otherwise in the application user interface 110, the active application 108 can use an application programming interface ("API"), e.g., provided by an operating system or another application of the user device 102. For instance, the active application 108 can use an API provided either by Google Play in Android or Apple in iOS.

When the active application 108 detects user interaction with the install element 118 within the active application 108, the active application 108 triggers, initiates, or otherwise causes installation of the other application while the active application 108 remains active. For instance, interaction with the install element 118 can cause the active application 108 to send a request to an application store server for an installation file for the other application, send a request to an operating system of the user device 102 to cause the operating system to install the other application, or both.

Continuing the above example, the document editor can receive, as the digital content 112, text that indicates a name for a worksheet application and a logo for the worksheet application. As the application store data 116, the document editor can obtain screenshots of the worksheet application, review data for the worksheet application, and an application installation quantity, e.g., that indicates how many times the worksheet application has been installed.

The document editor presents, in the application user interface 110, the worksheet application name and corresponding logo, both as the digital content 112. Concurrently with presentation of the digital content 112, the document editor presents the application store data 116 in the application store user interface 114. The document editor can present the digital content 112 and the application store user interface 114 with the unsupported content, e.g., to enable installation of the worksheet application and then presentation of the previously unsupported content.

In some implementations, the active application 108 can request content, receive content, or both, that will not be immediately presented upon receipt. In these implementations, the active application 108 can store the digital content 112, the application store data 116, or both, in a content cache 106. For example, when the active application 108 has a dynamic user interface, the active application 108 can cache content prior to presentation so that the active application 108 already has dynamic content for presentation and does not have to wait for a response from the content server 120, or another server, before presenting the dynamic content.

In some examples, the dynamic content can be a video, e.g., presented as part of a game. The active application 108 can receive, as the digital content, a video that references another application. The active application 108 can receive corresponding application store data for the other application. The active application 108 can store the video and the application store data in the content cache 106 for later use.

When the active application 108 stores data in the content cache 106 for later presentation, the active application 108 does not need to be active during receipt, storage, or both, of the data. For example, an application running in the background, e.g., minimized, can receive the digital content 112 and the application store data 116. The application can store the received data in the content cache 106. When the application is active, e.g., the active application 108, the application can present the digital content 112 and the application store user interface 114 in the application user interface 110.

The application store user interface 114, included in the application user interface 110, can have the same or a similar format to that of the application store's 104 user interface. For instance, the active application 108 can present the application store user interface 114 that has the same format, e.g., the same look and feel, as the application store's 104 user interface even though it is being presented within the active application 108.

In some examples, the application store user interface 114 can be customized based on one or more parameters. The parameters can include data for the user device 102, an account for the user device 102, the active application 108, the digital content 112, a size of an area in which the application store user interface 114 will be presented in the application user interface 110, a location of an area in which the application store user interface 114 will be presented in the application user interface 110, or a combination of two or more of these. This can enable the application store user interface 114 to have a similar look and feel to that of the application store's 104 user interface, while allowing for a customized presentation, e.g., given that the application store user interface 114 is not presented on an entire display for the user device 102.

The location of the area in which the application store user interface 114 will be presented can be a location on a display, e.g., top or bottom or left or right; a location within a user interface; or both. The location within the user interface can be a first content location, a second content location or a third content location, etc., which can be presented in the application user interface 110 after the active application 108 receives user input indicating a scroll action for, or otherwise moves through presentation of, the application user interface 110.

In some implementations, the application store data can be selected based on the one or more parameters. For instance, when the parameters include data representing the active application 108, e.g., an identifier for the active application 108, the content server 120 can select first application store data for a first identifier for a first active application or second application store data for a second identifier for a second active application. The first active application can be a document editor and the second active application can be a worksheet application. The application represented by both the first application store data and the second application store data can be a music application. In this example, the first application store data can indicate how the music application can be used in conjunction with the document editor and the second application store data can indicate how the music application can be used in conjunction with the worksheet application. This can enable the content server 120, in response to content requests received from different user devices 102, to provide different application store data 116 based on the context in which the application store data 116 will be presented.

To enable dynamic selection of application store data 116 based on a context in which the application store data 116 will be presented, the user device 102 can send one or more parameters to the content server 120 in a content request. For instance, the user device 102, e.g., the active application 108, can send data for the parameters mentioned above. The parameters can include a view presented, a digital content slot with which the application store user interface 114 will be presented, or other appropriate parameters.

In some examples, the content server 120 can provide application store data 116 that includes multiple data sets for a particular data type, e.g., multiple logos or views. A view can be a screenshot of the application represented by the application store data 116. The active application 108, or another component on the user device 102, can then select data from the multiple data sets for a particular data type for presentation with the digital content 112. For example, when the application store data 116 includes a first logo and a second logo, the active application 108 can select the first logo based on the sizes of the two logos and a size of the area in which the application store user interface 114 will be presented; based on a color scheme for the digital content and the application store user interface 114, e.g., by selecting the logo that most closely aligns with the color scheme; or based on another appropriate selection. This can ensure compatibility of the application store data 116 and the application store interface 114 with the digital content 112, the application user interface 110, the active application 108 and/or the user device 102. Moreover, multiple data sets can be provided at the same time, for example in a single message, which can further improve the versatility of the active application 108 and can enable more efficient provision of data. In particular, increased computational and bandwidth requirements associated with transmitting multiple messages can be avoided. Moreover, by providing multiple data sets upfront, latency associated with identifying an incompatibility and requesting additional data sets can be avoided, which can be particularly important when network conditions are poor.

The application store user interface 114 can be overlaid onto or embedded within the digital content 112. When the active application 108 presents an overlaid application store user interface 114, the active application 108 can generate two graphical user interface ("GUI") components: a first GUI component for presentation of the digital content 112 and a second GUI component for presentation of the application store user interface 114.

The active application 108 can then generate instructions for the presentation of the two GUI components such that the second GUI component for presentation of the application store user interface 114 is overlaid on top of the first GUI component for presentation of the digital content 112. This presentation can include changing a color of the presented digital content, e.g., to include a gray overlay to indicate that the second GUI component that presents the application store user interface 114 is the focus of the application user interface 110 and that user interaction with the first GUI component is disabled. The active application 108 can present the overlaid application store user interface 114 after presenting the digital content 112 for a predetermined period of time, or when another presentation criteria is satisfied, as discussed in more detail below. The area of the application user interface 110, e.g., the digital content 112, over which the application store user interface 114 is overlaid may not be rendered by the user device 102. This can reduce processing requirements through avoiding rendering of content that is going to be covered by other content.

When the active application 108 presents an embedded application store user interface 114, the active application 108 can generate a single GUI component for presentation of both the digital content 112 and the application store user interface 114. The single GUI component then presents both the digital content 112 and the application store user interface 114, as described in more detail below.

The content server 120 is an example of a system implemented as computer programs on one or more computers in one or more locations, in which the systems, components, and techniques described in this document are implemented. The user device 102 may include personal computers, mobile communication devices, and other devices that can send and receive data over a network 122. The network 122, such as a local area network (LAN), wide area network (WAN), the Internet, or a combination thereof, connects the user device 102, and the content server 120. The content server 120 may use a single server computer or multiple server computers operating in conjunction with one another, including, for example, a set of remote computers deployed as a cloud computing service.

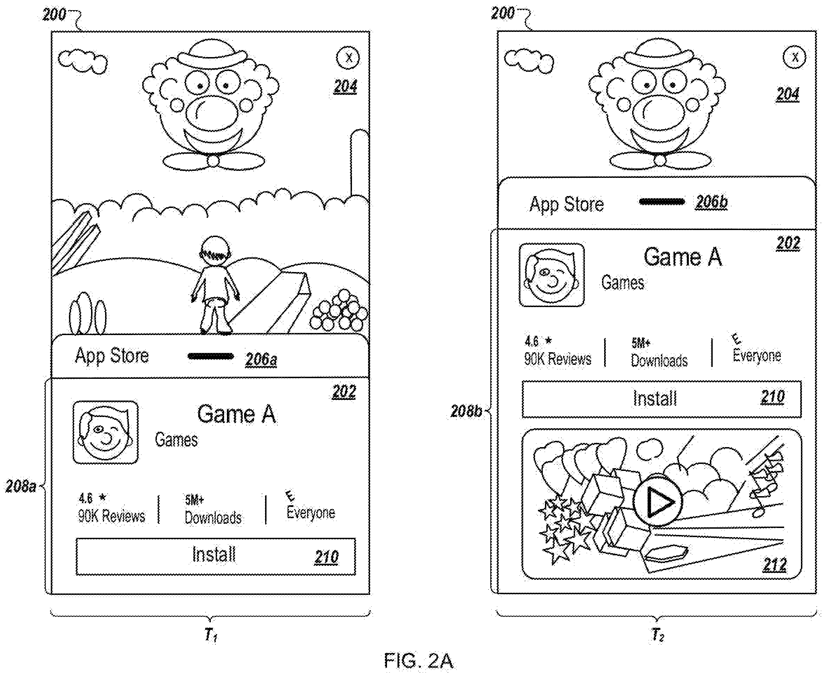

FIGS. 2A-B depict an example of a user interface 200 with an embedded application store user interface 202. The user interface 200 includes the embedded application store user interface 202 presented concurrently with digital content 204. The digital content 204 can include any appropriate type of digital content, such as an image or a video. Here, the digital content 204 is a video that presents information about another application that can provide additional functionality to an active application, e.g., the active application 108, that is presenting the user interface 200 on a display. For instance, the other application can be a second game that expands on the environment for a first game that is the active application 108, or completely unrelated to the active application 108.

The embedded application store user interface 202 can be embedded into any appropriate part of the user interface 200. For example, the embedded application store user interface 202 can be embedded in the digital content 204. In some examples, the embedded application store user interface 202 can be embedded directly in the user interface 200 itself.

The embedded application store user interface 202 can include a content size element 206a-b. The content size element 206a-b enables the embedded application store user interface 202 to adjust an amount of content presented in the embedded application store user interface 202, an amount of the digital content 204 depicted in the user interface 200, or both.

For instance, the embedded application store user interface 202 can present a first amount of application store data 208a for the other application during time period T₁ when the content size element 206a is at a first position. When the active application detects user interaction with the content size element 206a, moving the content size element from the first position to a second position represented by the content size element 206b during time period T₂, the active application, e.g., the embedded application store user interface 202, can adjust an amount of application store data 208b presented. For example, the embedded application store user interface 202 can present additional application store data in response to user interaction sliding the content size element 206a to the second position 206b. This can enable presentation of additional data 212, e.g., application store data, about the other application. The additional data 212 may have been received by the user device 102 integrally with the rest of the application store data 208b. This can enable more efficient provision of data through avoiding increased computational and bandwidth requirements associated with transmitting multiple messages. Moreover, latency associated with receiving the user interaction, processing the user interaction, requesting the additional data and receiving the additional data can be avoided, which can be particularly important when network conditions are poor.

The embedded application store user interface 202 includes an install element 210. The install element 210 enables installation of the other application on the user device that is executing the active application without causing the user device to switch from presenting the active application to presenting an application store. For instance, when the embedded application store user interface 202 detects user interaction with the install element 210 during time period T₁, the active application can cause installation of the other application on the user device. The installation process can include the active application providing the user device with information about the other application, e.g., an identifier or link for the other application, that the user device uses to download and install the other application.

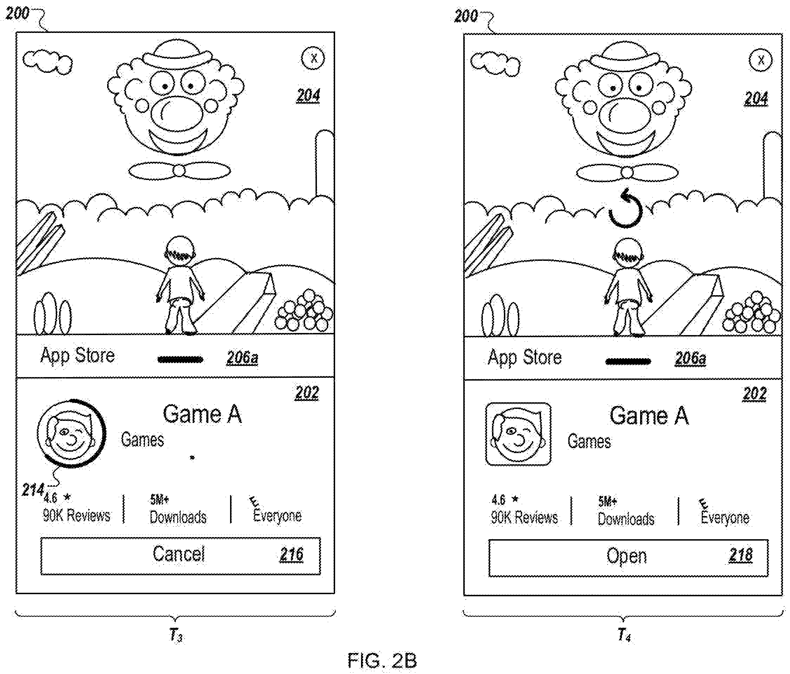

As shown in FIG. 2B, during time period T₃ when the user device is downloading, installing, or both, the other application, the embedded application store user interface 202 can present a progress element 214 that indicates a progress of the download process, the install process, or both. For instance, in response to the user interaction selecting the install element 210, the embedded application store user interface 202 can present the progress element 214. The user interaction selecting the install element 210 can be any appropriate type of user interaction. The user interaction can be voice input, e.g., "install", touch screen input, trackball input, or mouse input.

The embedded application store user interface 202 can present a cancel element 216 during the download process, install process, or both. For instance, when the user device initiates the download or install process, the embedded application store user interface 202 can include the cancel element 216 that enables cancellation of the download, install, or both, process.

When the digital content 204 is a video, the active application can play the video during the download process, the installation process, or both. For example, the active application can begin playback of the video during the time period T₁ and continue to play the video during time period T₃ when the user device installs the other application. This can reduce an amount of time necessary for the user device to both play the video and install the other application. In these implementations, the user interface 200 can include a stop element that stops playback of the video. For instance, the stop element can be presented with the digital content 204. Since the playing of the video and the installation of the other application can be performed concurrently and by the same application, these processes can be performed in a more time-efficient and more computational resource-efficient manner.

During time period T₄, after the other application has been installed, the embedded application store user interface 202 can present an open element 218, or allow the user to continue using the active application, e.g., in response to user interaction with a close element. The open element enables user input to cause the user device to open the other application, e.g., to switch to a user interface for the other application. When the other application is not currently executing on the user device and the embedded application store user interface 202 detects user interaction with the open element 218, the user device can launch the other application. The active application can provide data to the user device that causes the user device to open the other application. The data can indicate an identifier for the other application or other appropriate data.

The use of the user interface 200 with the embedded application store user interface 202 enables an active application, that is not an application store, to present digital content that references another application and application store data for the other application, without the user device switching to presentation of a separate application store application. This can enable the active application to provide information about a complementary application while reducing computer resources required to present the information.

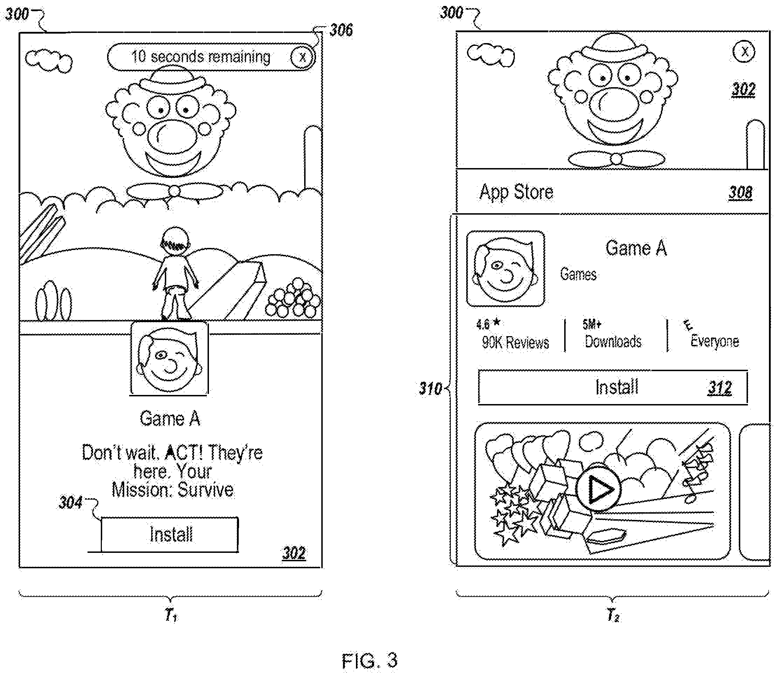

FIG. 3 depicts an example of a user interface 300 with an overlaid application store user interface. During a time period T₁, the user interface 300 depicts digital content 302 for an active application, e.g., the active application 108. The digital content 302 can provide information about, e.g., reference, another application that is a different application than the active application. For instance, when the active application is a game, the digital content can include a video, an image, or both, for another game by the same developer as the developer of the game.

The digital content 302 can include an application details element 304, e.g., a first install element 304. When the active application detects user interaction with the application details element 304, the active application can present an overlaid application store user interface 308.

When the active application does not detect user interaction with the application details element 304, a close element 306, or both, the active application can present the overlaid application store user interface 308 during time period T₂. The overlaid application store user interface 308 presents application store data 310 for the other application. For instance, the application store data 310 can include a name for the other application, a logo, rating data, number of installations data, screenshots for the other application, or a combination of two or more of these.

The overlaid application store user interface 308 includes a second install element 312. In contrast to the application details element 304 that enables presentation of the overlaid application store user interface 308, the second install element 312 can enable installation of the other application on the user device executing the active application. For instance, when the active application detects user interaction with the second install element 312, the active application can provide the user device with information about the other application, such as an identifier or a download link for the other application. The user device can use the received information to retrieve data for the other application, e.g., installation data. The user device can retrieve the data from an application store server or another appropriate system that maintains the data for the other application in memory. The user device can then install the other application, e.g., using the retrieved data. The overlaid application store user interface 308 can include one or more elements that indicate that the other application is being installed, e.g., a progress element, a cancel element, or both.

The overlaid application store user interface 308 can include a content size element or another element that enables user interaction with the depicted application store data 310. For instance, the element can enable a user to scroll through information about the other application, such as screenshots for the other application, reviews for the other application, or a description of the other application.

The active application can present the overlaid application store user interface 308 when a presentation criteria is satisfied. For instance, the active application can present the overlaid application store user interface 308 after determining that a predetermined period of time, e.g., ten seconds, has expired. The predetermined period of time can indicate a duration for which the active application presented the digital content 302. In some implementations, the active application can present the overlaid application store user interface 308 after a video, included in the digital content 302, has finished playing.

When the active application presents the overlaid application store user interface 308, the overlaid application store user interface 308 can disable user interaction with the digital content 302, user interface elements for the digital content 302, or both. For instance, when the digital content 302 includes the application details element 304, the close element 306, or both, presentation of the overlaid application store user interface 308 can disable user interaction with those elements.

The active application can detect user interaction requesting that the overlaid application store user interface 308 no longer be presented. The detected user interaction can be selection of an exit element for the overlaid application store user interface 308, an area above the overlaid application store user interface 308, e.g., in which the non-interactable digital content 302 is presented, or another appropriate user interaction.

As discussed above with reference to the embedded application store user interface 202, the overlaid application store user interface 308 can enable opening of another application after the other application has been installed. For instance, the overlaid application store user interface 308 can include an install element 312, a cancel element, or an open element depending on a stage of installation of another application. When the other application is not installed, the overlaid application store user interface 308 can depict the install element 312. During downloading, installation, or both, of the other application, the overlaid application store user interface 308 can include a cancel element that enables cancellation of the download process, installation process, or both. Once the other application is installed, the overlaid application store user interface 308 can depict the open element that causes the user device to open the other application.

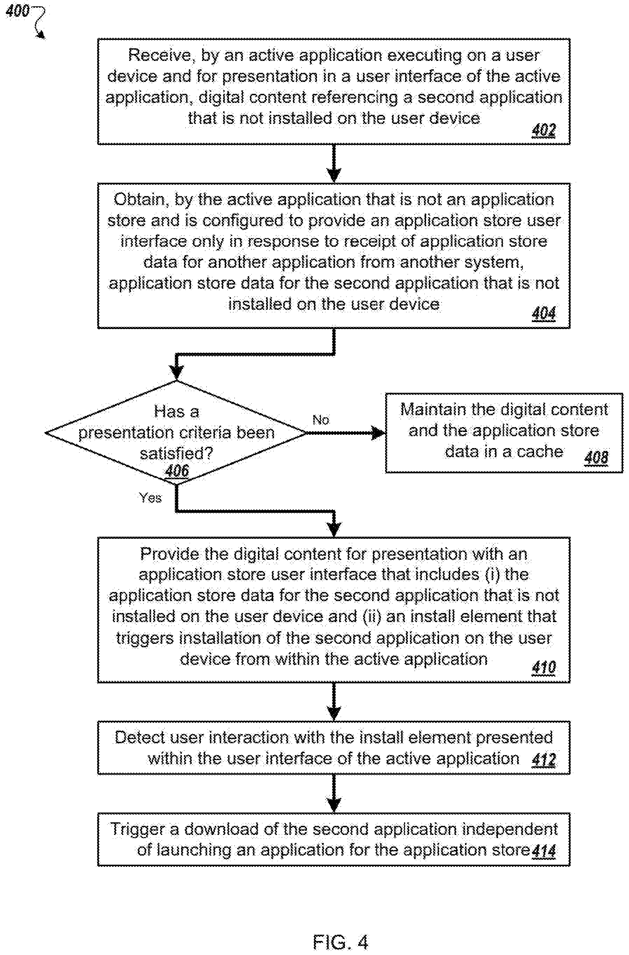

FIG. 4 is a flow diagram of a process 400 for causing presentation (e.g., concurrent presentation) of digital content with application store data. For example, the process 400 can be used by the active application 108 from the environment 100.

An active application, executing on a user device, receives, for presentation in a user interface of the active application, digital content referencing a second application that is not installed on the user device (402). The active application is not an application store application. Instead, the active application presents application store data, as described in more detail below.

The active application can receive the digital content from a content server. The content server can select the digital content in response to determination that the second application is not installed on a user device on which the active application is executing. For instance, the content server can receive data from the user device that identifies one or more applications installed on the user device and select digital content that references an application that is not installed on the user device, e.g., at the time the data was sent to the content server.

The active application obtains application store data for the second application that is not installed on the user device (404). The active application is not an application store. The active application can be configured to provide an application store user interface only in response to receipt of application store data for another application from another system. In some examples, the active application is not configured to provide application store data in response to user interaction that requests application store data.

The active application can obtain the application store data from any appropriate system. For example, the active application can obtain the application store data from a content server. The active application can obtain the application store data from another server, e.g., an application store server, different from the content server from which the active application receives the digital content.

The system can select the application store data based on a determination that the second application is not installed on the user device. For instance, when a system determines a second application that is not installed on the user device, the system can select application store data for that second application and provide the selected application store data to the active application. The system can provide an identifier for the second application to another system, e.g., a content server, when the other system provides the digital content to the active application.

In some examples, the system can receive an identifier for the second application from another system. For instance, when the other system determines that the second application is not installed on the user device executing the active application, the other system can provide an identifier for the second application to the system. The system can use the identifier to select the application store data and provide the application store data to the active application.

The application store data can be any appropriate application store data. For instance, the application store data can include application review data, application rating data, screenshots, an application description, or a combination of two or more of these.

The active application determines whether a presentation criteria has been satisfied (406). For instance, the active application can determine whether there is a user interface element slot in which to present the digital content and the application store data. The active application can determine whether it has detected user interaction that indicates a request for presentation of the digital content.

The user interaction can indicate a request for presentation of digital content that does not request presentation of application store data. In these examples, the active application can determine whether to present the application store data depending on a type of the digital content received, and need not obtain the application store data. For instance, the active application can determine digital content that does not reference a second application. Because the active application determines digital content that does not reference a second application, the active application does not obtain the application store data. The active application can then present the digital content alone, e.g., without any application store data. However, when the active application determines digital content that references a second application, the active application can obtain application store data.

In response to determining that the presentation criteria has not been satisfied, the active application maintains the digital content and the application store data in a cache (408). For example, after receiving the digital content and obtaining the application store data, the user device stores the digital content and the application store data in the cache. Once the active application presents the digital content and the application store data, the active application can remove, or maintain, the digital content and the application store data in the cache. Prior to presentation of the digital content and the application store data, when the presentation criteria has not been satisfied, the active application can maintain the digital content and the application store data in the cache, e.g., does not cause the deletion of the digital content and the application store data from the cache.

In some implementations, the active application can have a presentation criteria that indicates whether the digital content and the application store data should be presented concurrently. For instance, the presentation criteria can indicate a video finish event, e.g., when the digital content is a video, a time period, e.g., when the digital content is an image, or both. When the presentation criteria is a video finish event, the active application can determine whether a video, as the digital content, has finished playing. When the video has finished playing, the active application can determine that the presentation criteria is satisfied. When the presentation criteria is a time period, the active application can determine whether the digital content, e.g., an image, has been presented for a duration that satisfies, e.g., is equal to, the time period. When the active application determines that the digital content has been presented for a duration that satisfies the time period, the active application can determine that the presentation criteria is satisfied.

When the active application presents the digital content without the application store data, the presentation criteria can include a criteria that indicates that the active application has not detected user interaction with the digital content, e.g., selection of an install element or second application details element presented in the digital content. For instance, the active application can determine that the active application has not detected user interaction with the second application details element. In response, the active application can present an overlaid or embedded application store user interface, e.g., proceed to step 410, below.

While the active application determines that the presentation criteria is not satisfied, the active application can continue to present the digital content, e.g., without presenting the application store data. This can continue until the active application determines that the presentation criteria is satisfied.

In response to determining that the presentation criteria is satisfied, the active application provides the digital content for concurrent presentation with an application store user interface that includes (i) the application store data for the second application that is not installed on the user device and (ii) an install element that triggers installation of the second application on the user device from within the active application (410). The active application can provide the digital content for concurrent presentation with the application store user interface. For example, the active application can provide the digital content for concurrent presentation with an embedded application store user interface or an overlaid application store user interface.

In some implementations, when the active application presents digital content without presentation of the application store data and the application store user interface, the active application need not detect user interaction that requests presentation of the application store data or the application store user interface. Instead, the active application automatically, without user input, presents the application store user interface, e.g., in an overlaid application store user interface, concurrently with the digital content.

The active application can provide the digital content for concurrent presentation with the application store user interface in any appropriate manner. For instance, the active application can present the digital content concurrently with the application store user interface on a display. In some examples, the active application can provide, to a display or a graphics processing unit, data for the digital content and the application store user interface to cause the display or the graphics processing unit to concurrently present the digital content and the application store user interface.

The active application detects user interaction with the install element presented within the user interface of the active application (412). For example, the active application detects user input selecting the install element. In some examples, the active application can detect a voice command, e.g., "install", or receive data that identifies a voice command, e.g., when another application on the user device detects the voice command.

The active application triggers a download of the second application independent of launching an application for the application store (414). For instance, the active application provides data to the user device that causes the user device to download the second application. The user device can use the downloaded data to install the second application on the user device. In some examples, after installing the second application, the user device can launch the second application, e.g., when the active application detects user interaction with an open element that is presented in the application store user interface after installation of the second application. The user device can perform any of these actions without launching an application for the application store.

The order of steps in the process 400 described above is illustrative only, and causing the presentation of digital content with application store data can be performed in different orders. For example, the active application can obtain the application store data prior to or concurrently with receipt of the digital content. In some examples, the active application obtains the application store data in the same message, or group of messages, in which the active application receives the digital content. For instance, the active application can receive a set of messages from a server, e.g., a content server, that each include the same message identifier and, combined, include data for both the digital content and the application store data.

In some implementations, the process 400 can include additional steps, fewer steps, or some of the steps can be divided into multiple steps. For example, the active application can perform steps 402 through 406 and 410 without performing the other steps in the process 400. In some examples, the active application can perform steps 404, and 410 without performing the other steps in the process. In some examples, the active application can perform steps 402, 404, and 410 without performing the other steps in the process 400. In some examples, the active application can perform steps 402, 404, 410, 412, and 414 without performing the other steps in the process 400.

In some implementations, the active application can request digital content prior to receiving the digital content. The request can be a request for digital content without requesting application store data.

The digital content can be any appropriate digital content. For instance, the digital content can be a video presented as part of a game. In some examples, the digital content can be an advertisement. For example, when the game is a virtual reality game, the digital content can be part of an advertisement that will be presented in a three-dimensional virtual environment, e.g., on a billboard that is part of the virtual environment.

In some implementations, an active application can present any appropriate data for an embedded or overlaid application instead of the application store data. For instance, the active application can receive digital content that references a second application or a product. The active application can obtain application data, instead of application store data, that also references the second application or product. The active application can then present, in its user interface, the digital content and another application's user interface, the latter of which depicts the application data. In this way, the active application can present data in a user interface for another application, e.g., whether overlaid or embedded, that references a second application or product along with the digital content that references the same second application or product.

In some implementations, the active application, or the user device, can receive multiple sets of digital content that each reference the same second application. When the active application or the user device, e.g., two different applications executing on the user device, presents each of the different sets of digital content, the active application can present the same application store data for the second application. For instance, the active application can present, in a first user interface slot, first digital content, e.g., an image, that references a second application concurrently with an application store user interface that depicts the application store data for the second application. The active application can later present, in a second user interface slot, second digital content, e.g., a video. Concurrently with presentation of the second digital content, the active application can present the application store user interface that includes the same application store data that was presented with the first digital content. The active application can present the second digital content in the same user interface slot as the application store user interface.

For situations in which the systems discussed here make use of personal information or device information, the users may be provided with an opportunity to control whether programs or features collect personal information (e.g., information about a user's social network, social actions or activities, profession, a user's preferences, or a user's current location), or to control whether and/or how to receive content from the content server that may be more relevant to the user. In addition, certain data may be anonymized in one or more ways before it is stored or used, so that personally identifiable information is removed. For example, a user's identity or a device's identity may be anonymized so that no personally identifiable information can be determined for the user or the device. In some examples, an identity need not be used, and instead a system can use data about applications installed on a device without using, or receiving, an identifier for the device. Thus, the user may have control over how information is collected about him or her and used by a content server.

A number of implementations have been described. Nevertheless, it will be understood that various modifications may be made without departing from the spirit and scope of the disclosure. For example, various forms of the flows shown above may be used, with steps re-ordered, added, or removed.

Embodiments of the subject matter and the functional operations described in this specification can be implemented in digital electronic circuitry, in tangibly-embodied computer software or firmware, in computer hardware, including the structures disclosed in this specification and their structural equivalents, or in combinations of one or more of them. Embodiments of the subject matter described in this specification can be implemented as one or more computer programs, i.e., one or more modules of computer program instructions encoded on a tangible non-transitory program carrier for execution by, or to control the operation of, data processing apparatus. Alternatively or in addition, the program instructions can be encoded on an artificially-generated propagated signal, e.g., a machine-generated electrical, optical, or electromagnetic signal, that is generated to encode information for transmission to suitable receiver apparatus for execution by a data processing apparatus. The computer storage medium can be a machine-readable storage device, a machine-readable storage substrate, a random or serial access memory device, or a combination of one or more of them.

The term "data processing apparatus" refers to data processing hardware and encompasses all kinds of apparatus, devices, and machines for processing data, including by way of example a programmable processor, a computer, or multiple processors or computers. The apparatus can also be or further include special purpose logic circuitry, e.g., an FPGA (field programmable gate array) or an ASIC (application-specific integrated circuit). The apparatus can optionally include, in addition to hardware, code that creates an execution environment for computer programs, e.g., code that constitutes processor firmware, a protocol stack, a database management system, an operating system, or a combination of one or more of them.

A computer program, which may also be referred to or described as a program, software, a software application, a module, a software module, a script, or code, can be written in any form of programming language, including compiled or interpreted languages, or declarative or procedural languages, and it can be deployed in any form, including as a stand-alone program or as a module, component, subroutine, or other unit suitable for use in a computing environment. A computer program may, but need not, correspond to a file in a file system. A program can be stored in a portion of a file that holds other programs or data, e.g., one or more scripts stored in a markup language document, in a single file dedicated to the program in question, or in multiple coordinated files, e.g., files that store one or more modules, sub-programs, or portions of code. A computer program can be deployed to be executed on one computer or on multiple computers that are located at one site or distributed across multiple sites and interconnected by a communication network.

The processes and logic flows described in this specification can be performed by one or more programmable computers executing one or more computer programs to perform functions by operating on input data and generating output. The processes and logic flows can also be performed by, and apparatus can also be implemented as, special purpose logic circuitry, e.g., an FPGA (field programmable gate array) or an ASIC (application-specific integrated circuit).

Computers suitable for the execution of a computer program include, by way of example, general or special purpose microprocessors or both, or any other kind of central processing unit. Generally, a central processing unit will receive instructions and data from a read-only memory or a random access memory or both. The essential elements of a computer are a central processing unit for performing or executing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. However, a computer need not have such devices. Moreover, a computer can be embedded in another device, e.g., a mobile telephone, a smart phone, a personal digital assistant (PDA), a mobile audio or video player, a game console, a Global Positioning System (GPS) receiver, or a portable storage device, e.g., a universal serial bus (USB) flash drive, to name just a few.

Computer-readable media suitable for storing computer program instructions and data include all forms of non-volatile memory, media and memory devices, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in, special purpose logic circuitry.

To provide for interaction with a user, embodiments of the subject matter described in this specification can be implemented on a computer having a display device, e.g., LCD (liquid crystal display), OLED (organic light emitting diode) or other monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's device in response to requests received from the web browser.

Embodiments of the subject matter described in this specification can be implemented in a computing system that includes a back-end component, e.g., as a data server, or that includes a middleware component, e.g., an application server, or that includes a front-end component, e.g., a client computer having a graphical user interface or a Web browser through which a user can interact with an implementation of the subject matter described in this specification, or any combination of one or more such back-end, middleware, or front-end components. The components of the system can be interconnected by any form or medium of digital data communication, e.g., a communication network. Examples of communication networks include a local area network (LAN) and a wide area network (WAN), e.g., the Internet.

The computing system can include clients and servers. A client and server are generally remote from each other and typically interact through a communication network. The relationship of client and server arises by virtue of computer programs running on the respective computers and having a client-server relationship to each other. In some embodiments, a server transmits data, e.g., an Hypertext Markup Language (HTML) page, to a user device, e.g., for purposes of displaying data to and receiving user input from a user interacting with the user device, which acts as a client. Data generated at the user device, e.g., a result of the user interaction, can be received from the user device at the server.

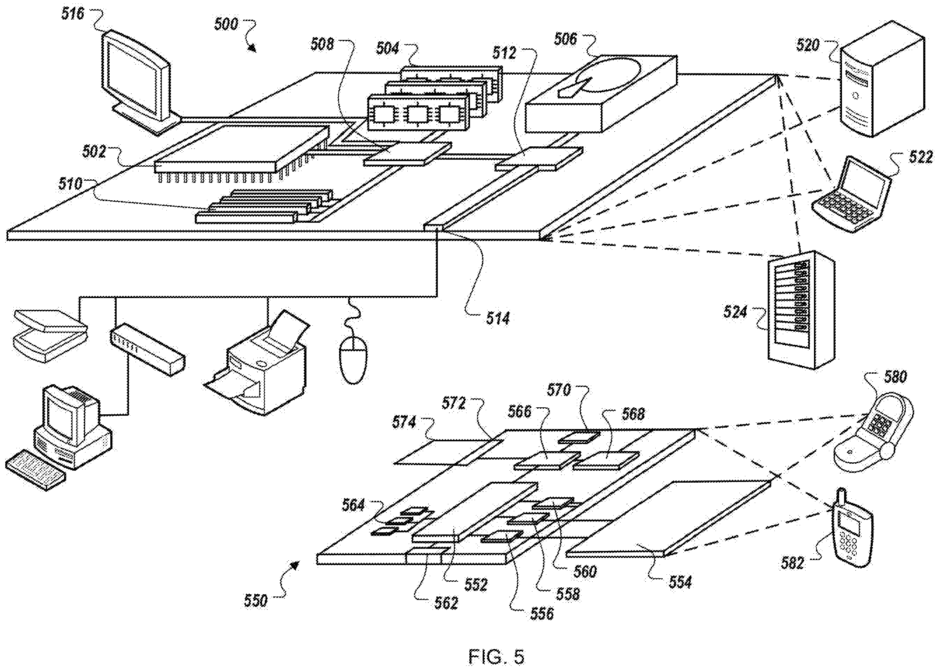

FIG. 5 is a block diagram of computing devices 500, 550 that may be used to implement the systems and methods described in this document, as either a client or as a server or plurality of servers. Computing device 500 is intended to represent various forms of digital computers, such as laptops, desktops, workstations, personal digital assistants, servers, blade servers, mainframes, and other appropriate computers. Computing device 550 is intended to represent various forms of mobile devices, such as personal digital assistants, cellular telephones, smartphones, smartwatches, head-worn devices, and other similar computing devices. The components shown here, their connections and relationships, and their functions, are meant to be exemplary only, and are not meant to limit implementations described and/or claimed in this document.

Computing device 500 includes a processor 502, memory 504, a storage device 506, a high-speed interface 508 connecting to memory 504 and high-speed expansion ports 510, and a low speed interface 512 connecting to low speed bus 514 and storage device 506. Each of the components 502, 504, 506, 508, 510, and 512, are interconnected using various busses, and may be mounted on a common motherboard or in other manners as appropriate. The processor 502 can process instructions for execution within the computing device 500, including instructions stored in the memory 504 or on the storage device 506 to display graphical information for a GUI on an external input/output device, such as display 516 coupled to high speed interface 508. In other implementations, multiple processors and/or multiple buses may be used, as appropriate, along with multiple memories and types of memory. Also, multiple computing devices 500 may be connected, with each device providing portions of the necessary operations (e.g., as a server bank, a group of blade servers, or a multi-processor system).

The memory 504 stores information within the computing device 500. In one implementation, the memory 504 is a computer-readable medium. In one implementation, the memory 504 is a volatile memory unit or units. In another implementation, the memory 504 is a non-volatile memory unit or units.

The storage device 506 is capable of providing mass storage for the computing device 500. In one implementation, the storage device 506 is a computer-readable medium. In various different implementations, the storage device 506 may be a floppy disk device, a hard disk device, an optical disk device, or a tape device, a flash memory or other similar solid state memory device, or an array of devices, including devices in a storage area network or other configurations. In one implementation, a computer program product is tangibly embodied in an information carrier. The computer program product contains instructions that, when executed, perform one or more methods, such as those described above. The information carrier is a computer- or machine-readable medium, such as the memory 504, the storage device 506, or memory on processor 502.

The high speed controller 508 manages bandwidth-intensive operations for the computing device 500, while the low speed controller 512 manages lower bandwidth-intensive operations. Such allocation of duties is exemplary only. In one implementation, the high-speed controller 508 is coupled to memory 504, display 516 (e.g., through a graphics processor or accelerator), and to high-speed expansion ports 510, which may accept various expansion cards (not shown). In the implementation, low-speed controller 512 is coupled to storage device 506 and low-speed expansion port 514. The low-speed expansion port, which may include various communication ports (e.g., USB, Bluetooth, Ethernet, wireless Ethernet) may be coupled to one or more input/output devices, such as a keyboard, a pointing device, a scanner, or a networking device such as a switch or router, e.g., through a network adapter.

The computing device 500 may be implemented in a number of different forms, as shown in the figure. For example, it may be implemented as a standard server 520, or multiple times in a group of such servers. It may also be implemented as part of a rack server system 524. In addition, it may be implemented in a personal computer such as a laptop computer 522. Alternatively, components from computing device 500 may be combined with other components in a mobile device (not shown), such as device 550. Each of such devices may contain one or more of computing device 500, 550, and an entire system may be made up of multiple computing devices 500, 550 communicating with each other.

Computing device 550 includes a processor 552, memory 564, an input/output device such as a display 554, a communication interface 566, and a transceiver 568, among other components. The device 550 may also be provided with a storage device, such as a microdrive or other device, to provide additional storage. Each of the components 550, 552, 564, 554, 566, and 568, are interconnected using various buses, and several of the components may be mounted on a common motherboard or in other manners as appropriate.

The processor 552 can process instructions for execution within the computing device 550, including instructions stored in the memory 564. The processor may also include separate analog and digital processors. The processor may provide, for example, for coordination of the other components of the device 550, such as control of user interfaces, applications run by device 550, and wireless communication by device 550.

Processor 552 may communicate with a user through control interface 558 and display interface 556 coupled to a display 554. The display 554 may be, for example, a TFT LCD display or an OLED display, or other appropriate display technology. The display interface 556 may comprise appropriate circuitry for driving the display 554 to present graphical and other information to a user. The control interface 558 may receive commands from a user and convert them for submission to the processor 552. In addition, an external interface 562 may be provided in communication with processor 552, so as to enable near area communication of device 550 with other devices. External interface 562 may provide, for example, for wired communication (e.g., via a docking procedure) or for wireless communication (e.g., via Bluetooth or other such technologies).

The memory 564 stores information within the computing device 550. In one implementation, the memory 564 is a computer-readable medium. In one implementation, the memory 564 is a volatile memory unit or units. In another implementation, the memory 564 is a non-volatile memory unit or units. Expansion memory 574 may also be provided and connected to device 550 through expansion interface 572, which may include, for example, a SIMM card interface. Such expansion memory 574 may provide extra storage space for device 550, or may also store applications or other information for device 550. Specifically, expansion memory 574 may include instructions to carry out or supplement the processes described above, and may include secure information also. Thus, for example, expansion memory 574 may be provided as a security module for device 550, and may be programmed with instructions that permit secure use of device 550. In addition, secure applications may be provided via the SIMM cards, along with additional information, such as placing identifying information on the SIMM card in a non-hackable manner.

The memory may include for example, flash memory and/or MRAM memory, as discussed below. In one implementation, a computer program product is tangibly embodied in an information carrier. The computer program product contains instructions that, when executed, perform one or more methods, such as those described above. The information carrier is a computer- or machine-readable medium, such as the memory 564, expansion memory 574, or memory on processor 552.

Device 550 may communicate wirelessly through communication interface 566, which may include digital signal processing circuitry where necessary. Communication interface 566 may provide for communications under various modes or protocols, such as GSM voice calls, SMS, EMS, or MMS messaging, CDMA, TDMA, PDC, WCDMA, CDMA2000, or GPRS, among others. Such communication may occur, for example, through radio-frequency transceiver 568. In addition, short-range communication may occur, such as using a Bluetooth, WiFi, or other such transceiver (not shown). In addition, GPS receiver module 570 may provide additional wireless data to device 550, which may be used as appropriate by applications running on device 550.

Device 550 may also communicate audibly using audio codec 560, which may receive spoken information from a user and convert it to usable digital information. Audio codec 560 may likewise generate audible sound for a user, such as through a speaker, e.g., in a handset of device 550. Such sound may include sound from voice telephone calls, may include recorded sound (e.g., voice messages, music files, etc.) and may also include sound generated by applications operating on device 550.

The computing device 550 may be implemented in a number of different forms, as shown in the figure. For example, it may be implemented as a cellular telephone 580. It may also be implemented as part of a smartphone 582, personal digital assistant, or other similar mobile device.

Various implementations of the systems and techniques described here can be realized in digital electronic circuitry, integrated circuitry, specially designed ASICs (application specific integrated circuits), computer hardware, firmware, software, and/or combinations thereof. These various implementations can include implementation in one or more computer programs that are executable and/or interpretable on a programmable system including at least one programmable processor, which may be special or general purpose, coupled to receive data and instructions from, and to transmit data and instructions to, a storage system, at least one input device, and at least one output device.

These computer programs (also known as programs, software, software applications or code) include machine instructions for a programmable processor, and can be implemented in a high-level procedural and/or object-oriented programming language, and/or in assembly/machine language. As used herein, the terms "machine-readable medium" "computer-readable medium" refers to any computer program product, apparatus and/or device (e.g., magnetic discs, optical disks, memory, Programmable Logic Devices (PLDs)) used to provide machine instructions and/or data to a programmable processor, including a machine-readable medium that receives machine instructions as a machine-readable signal. The term "machine-readable signal" refers to any signal used to provide machine instructions and/or data to a programmable processor.

While this specification contains many specific implementation details, these should not be construed as limitations on the scope of what may be claimed, but rather as descriptions of features that may be specific to particular embodiments. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system modules and components in the embodiments described above should not be understood as requiring such separation in all embodiments, and it should be understood that the described program components and systems can generally be integrated together in a single software product or packaged into multiple software products.

In each instance where an HTML file is mentioned, other file types or formats may be substituted. For instance, an HTML file may be replaced by an XML, JSON, plain text, or other types of files. Moreover, where a table or hash table is mentioned, other data structures (such as spreadsheets, relational databases, or structured files) may be used.

Particular embodiments of the invention have been described. Other embodiments are within the scope of the following claims. For example, the steps recited in the claims, described in the specification, or depicted in the figures can be performed in a different order and still achieve desirable results. In some cases, multitasking and parallel processing may be advantageous.

Aspects of the present disclosure are summarised by the following numbered clauses:
Clause 1: A computer-implemented method comprising:
   receiving, by an active application executing on a user device that is not an application store and for display in a user interface of the active application, digital content referencing a second application that is not installed on the user device;
   obtaining, from one or more servers and by the active application that is not the application store, application store data for the second application that is not installed on the user device;
   providing, by the active application and in the user interface of the active application, the digital content with an application store user interface that includes (i) the application store data for the second application that is not installed on the user device and (ii) an install element for triggering installation of the second application on the user device from within the active application;
   detecting user interaction with the install element provided within the user interface of the active application; and
   in response to detecting the user interaction with the install element, triggering a download of the second application independent of launching an application for the application store.
Clause 2: The method of clause 1, wherein:
   obtaining the application store data comprises receiving, by the active application that is not the application store and from another system, the application store data for the second application that is not installed on the user device; and
   providing the digital content with the application store user interface comprises providing the application store user interface in response to receiving, from the other system, the application store data.
Clause 3: The method of any preceding clause, wherein providing the digital content with the application store user interface comprises displaying the digital content with the application store user interface.
Clause 4: The method of any preceding clause, wherein providing the digital content with the application store user interface comprises providing, to a display unit, data for the digital content and the application store user interface to cause the display unit to display the digital content and the application store user interface.
Clause 5: The method of any preceding clause, wherein providing the digital content with the application store user interface that includes the application store data comprises presenting, in the user interface of the active application, the digital content with an embedded application store user interface that includes the application store data.
Clause 6: The method of any preceding clause, wherein providing the digital content with the application store user interface that includes the application store data comprises presenting the digital content with an overlaid application store user interface that includes the application store data.
Clause 7: The method of any preceding clause, comprising:
   displaying, by the active application, the digital content in the user interface without the application store data; and
   determining that a presentation time period of the digital content is satisfied, wherein displaying the digital content with the overlaid application store user interface is responsive to determining that the presentation time period of the digital content is satisfied.
Clause 8: The method of any preceding clause, wherein the digital content includes a second application details element, the method comprising:
   determining, by the active application, that the active application has not detected user interaction with the second application details element, wherein displaying the digital content with the overlaid application store user interface is responsive to:
   determining that the active application has not detected user interaction with the second application details element; and
   determining that the presentation time period of the digital content is satisfied.
Clause 9: The method of any preceding clause, wherein obtaining the application store data comprises obtaining the application store data in a message that includes the digital content.
Clause 10: The method of any preceding clause, comprising:
   prior to providing the digital content with the application store user interface, caching the digital content and the application store data; and
   determining that a presentation criteria is satisfied, wherein providing the digital content with the application store user interface is responsive to determining that the presentation criteria is satisfied.
Clause 11: The method of any preceding clause, wherein:
   determining that the presentation criteria is satisfied comprises detecting, by the active application, a user interaction that requests presentation of the digital content; and
   providing the digital content with the application store user interface is responsive to detecting the user interaction that requests presentation of the digital content.
Clause 12: The method of any preceding clause, wherein:
   detecting the user interaction that requests presentation of the digital content comprises detecting the user interaction that requests presentation of any digital content and does not request presentation of any application store data; and
   providing the digital content with the application store user interface that includes the application store data is responsive to detecting the user interaction that requests presentation of any digital content and does not request presentation of any application store data.
Clause 13: The method of any preceding clause, wherein:
   obtaining the application store data comprises obtaining, from another system, the application store data that was selected based on a determination that the second application is not installed on the user device.
Clause 14: A non-transitory computer storage medium encoded with instructions that, when executed by one or more computers, cause the one or more computers to perform the method of any preceding clause.
Clause 15: A system comprising one or more computers and one or more storage devices on which are stored instructions that are operable, when executed by the one or more computers, to cause the one or more computers to perform the method of any of clauses 1 to 13.

## Claims

1. A computer-implemented method comprising:
receiving, by an application (108) executing on a user device (102) that is not an application store, a single content response from a content server (120), wherein the single content response comprises both digital content (112) referencing a second application that is not installed on the user device and application store data (116) for the second application;
in response to receiving the single content response and when the application is an active application, providing, by the active application and in a user interface (110) of the active application, the digital content concurrently with an application store user interface (114) that includes (i) the application store data for the second application and (ii) an install element (118) for triggering installation of the second application on the user device from within the active application;
detecting user interaction with the install element provided within the user interface of the active application; and
in response to detecting the user interaction with the install element, triggering a download of the second application independent of launching an application for the application store.

2. The method of claim 1, wherein providing the digital content with the application store user interface comprises generating a single graphical user interface, GUI, component for presentation of both the digital content and the application store user interface.

3. The method of claim 1 or 2, wherein the application store user interface includes a size control, and the method further comprises:
detecting user interaction with the size control; and
in response to the user interaction, dynamically changing a size of a portion of the user interface in which the application store user interface is presented.

4. The method of any preceding claim, wherein the digital content comprises a video, the method comprising:
playing the video during a first time period prior to detecting the user interaction with the install element; and
continuing to play the video during a second time period while the user device downloads or installs the second application.

5. The method of claim 4, further comprising presenting, within the user interface, a stop element for stopping playback of the video, wherein the stop element is presented with the digital content.

6. The method of any preceding claim, further comprising:
after the second application has been installed, presenting an open element in the application store user interface; and
in response to detecting user interaction with the open element, causing the user device to launch the second application.

7. The method of any preceding claim, wherein:
the application store data included in the single content response comprises multiple data sets for a particular data type; and
the method further comprises selecting data from the multiple data sets for presentation based on a size of an area in which the application store user interface will be presented.

8. The method of any preceding claim, wherein providing the application store user interface is performed automatically by the active application without requiring user input, responsive to a trigger comprising either (i) expiration of a predetermined presentation time period of the digital content or (ii) completion of a video playback.

9. The method of any preceding claim, further comprising receiving and storing the application store data in a content cache while the application is running in a background or minimised state.

10. A non-transitory computer storage medium encoded with instructions that, when executed by one or more computers, cause the one or more computers to perform the method of any preceding claim.

11. A system comprising one or more computers and one or more storage devices on which are stored instructions that are operable, when executed by the one or more computers, to cause the one or more computers to perform the method of any one of claims 1 to 9.
